# EUROPEAN PATENT SPECIFICATION

(11) **EP 2 051 850 B1**
(45) Date of publication and mention of the grant of the patent: **18.11.2009**
(21) Application number: 07814146.2
(22) Date of filing: 16.08.2007
(51) Int. Cl.: B32B 5/18, B32B 15/08, B32B 33/00, C09D 5/00

(54) **COATINGS AND METHODS FOR INHIBITING TIN WHISKER GROWTH**
BESCHICHTUNGEN UND VERFAHREN ZUR HEMMUNG VON ZINNWHISKERWACHSTUM
REVÊTEMENTS ET PROCÉDÉS POUR INHIBER LA CROISSANCE DE BARBES D'ÉTAIN

(30) Priority: 18.08.2006 US 506541
(43) Date of publication of application: 29.04.2009
(73) Proprietor: Honeywell International, Inc., Morristown NJ 07962 (US)
(72) Inventor: JACKSON, Merrill M., Tucson, Arizona 85742 (US); HUMPHREY, David, Tucson, Arizona 85718 (US)
(74) Representative: Buckley, Guy Julian
(86) International application number: PCT/US2007/076066
(87) International publication number: WO 2008/022236

(56) References cited:
- JP-A- 2006 111 898
- US-A1- 2002 185 716
- US-A1- 2004 072 012
- US-B1- 6 248 455

## Description

### CROSS-REFERENCES TO RELATED APPLICATIONS

This application claims the benefit of U.S. Provisional Application No. 60/811,609, filed June 7,2006.

### TECHNICAL FIELD

The present invention relates to new or refurbished electronic assemblies or assembly components that may have a metal plating or finish, and more particularly to such assemblies or components having a tin plating or finish.

### BACKGROUND

Electronic assemblies or assembly components are often plated or finished with a metal. Printed wiring boards and electrical leads are just some examples of many components that typically have a metal finish. Perhaps the most abundant metal composition for a plating or a finish has been lead/tin (PbSn). However, laws and directives recently passed in several countries encourage or require the elimination of lead by those procuring, designing, building, or repairing electronic assemblies. The restriction of lead use has generated a transition by many piece part and board suppliers from PbSn surface finishes to lead-free finishes such as pure tin.

Tin finishes may be susceptible to spontaneous growth of single crystal structures known as tin whiskers. Tin whiskers are cylindrical, needle-like crystals that may grow either straight or kinked, and usually have a longitudinally striated surface. Growth rates for tin whiskers vary, although rates from 0.03 to 9 mm/yr have been reporter. Interrelated factors including substrate materials, grain structure, plating chemistry, and plating thickness may influence growth rate. Although the whister length depends on growth rate and sustained periods of growth, in experimental tests most measure between 0.5 and 5.0 mm although whiskers having a length of more than to 10 mm have been reported. The growth mechanisms for tin whiskers are largely unknown, although it is widely believed that whisker formation and growth are correlated with stresses such as localized compressive forces and environmental stresses on the tin plating or finish. Additional factors that may influence tin whisker growth include the materials constituting the substrate underlying the tin, and specifically a significant difference in the coefficients of thermal expansion between tin and the underlying substrate material since such a difference may stress the tin.

Tin whiskers may cause electrical failures ranging from performance degradation to short circuits. In some cases, the elongate structures have interfered with sensitive optical surfaces or the movement of micro-electromechanical systems (MEMS). Thus, tin whiskers are a potential reliability hazard. It is therefore desirable to provide materials and manufacturing procedures that mitigate the tendencies of pure tin and tin-containing solders, platings, and finishes to form tin whiskers. It is also desirable to provide such materials and methods that minimize the use of lead-containing compositions such as Pb/Sn solder.

### BRIEF SUMMARY

The present invention provides an electrical component, comprising a conductive substrate, a tin layer formed on the substrate, and a conformal coating formed on the tin layer to impede tin whisker growth. The conformal coating comprises a polymer matrix having gas-filled voids dispersed therethrough.

The present invention also provides a method for impeding tin whisker growth from a tin plating or finish formed over an electrical component. First, a gas is infused into a liquid polymer. The tin plating or finish is then covered with a conformal coating comprising the liquid polymer. Then, one or more of the temperature and pressure of the conformal coating are adjusted to thereby create a dispersion of gas-filled voids comprising the gas in the conformal coating.

Other independent features and advantages of the preferred coatings and coating methods will become apparent from the following detailed description, taken in conjunction with the accompanying drawings which illustrate, by way of example, the principles of the invention.

### BRIEF DESCRIPTION OF THE DRAWINGS

FIG. 1 is a cross-sectional view of a tin finished electrical component having a conformal coating with gas-filled voids according to a first embodiment of the present invention: and

FIG. 2 is a flow diagram illustrating an exemplary method for forming a conformal coating with gas-filled voids.

### DETAILED DESCRIPTION OF A PREFERRED EMBODIMENT

There is no intention to be bound by any theory presented in the preceding background of the invention or the following detailed description of the invention.

Electrical assemblies and components of the present invention have a tin plating or finish, and a conformal coating around the tin plating or finish. Growth of tin whiskers through the conformal coating is inhibited by gas-filled voids within the coating matrix material. Tin whiskers are able to grow until they enter the gas-filled voids. However, the lack of lateral support for the tin whiskers inside the voids causes growing tin whiskers to buckle and consequently fail to reenter the conformal coating matrix material. Thus, tin whiskers fail to exit, or grow a substantial distance from, the conformal coating outer surface.

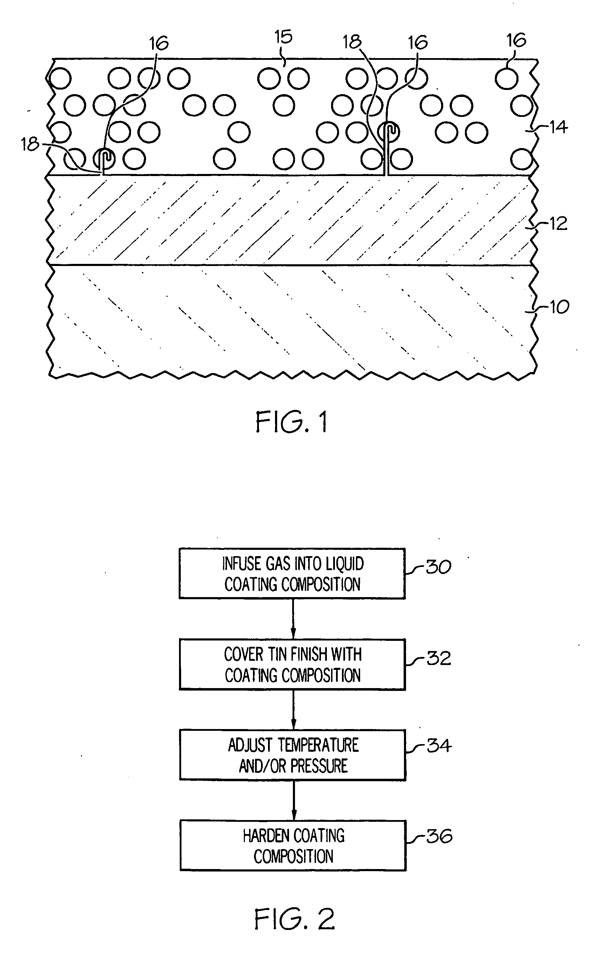

Turning now to FIG. 1, an electrical component substrate 10 having a tin finish 12 is depicted, with a conformal coating 14 formed over the tin finish 12. Just some examples of the substrate 10 include a circuit card assembly, a wiring board, one or more components printed on a wiring board, and one or more conductive leads. The conformal coating 14 includes a relatively soft matrix material. Exemplary conformal coatings are polymers including urethane, silicone, acrylic, paralenes, and polymers having an epoxy group in the molecule thereof. As previously discussed, conventional conformal coatings that consist of the same matrix materials may be somewhat susceptible to penetration by tin whiskers 18 as illustrated in FIG. 1. For this reason, the conformal coating 14 includes a dispersion of gas-filled voids 16, inside of which the tin whiskers 18 will buckle instead of growing through the conformal coating 14.

The gas-filled voids 16 are dispersed in a manner whereby the tin whiskers 18 have a high probability of encountering and entering at least one void 16 instead of growing through the conformal coating 14. In other words, any tin whisker growing perpendicularly from any point along the tin finish surface interfacing with the conformal coating 14 has a high probability of entering at least one gas-filled void 16, For this reason, an exemplary conformal coating 14 includes multiple layers of the hard particles 16, and preferably more than two particle layers, although the "layers" simply constitute numerous gas-filled voids at various depths rather than discrete gas void-containing levels. A conformal coating 14 having a thickness as small as 50 microns may include five to ten layers of gas-filled voids 16, with the voids preferably having diameters ranging between 5 and 10 microns. Depending on the overall coating thickness, larger or smaller gas-fined voids 16 may be included to provide a high probability for a tin whisker to encounter a void 16 before pushing through the entire conformal coating thickness. For example, thicker coatings may include gas-filled voids having an average diameter of up to 40 microns. As depicted in FIG. 1, one tin whisker 18 will enter a gas-filled void 16 that is situated close to the tin finish 12 and will consequently buckle when, upon traversing the void 16, colliding with the conformal coating matrix surrounding the void 16. Other tin whiskers may grow between some gas-filled voids disposed closest to the tin finish 12, but will eventually enter a more outwardly disposed gas-filled void. The voids 16 may be randomly dispersed, and are preferably homogenously dispersed, at a sufficient concentration to provide a high probability for a tin whisker 18 to enter at least one void 16.

As illustrated in FIG. 1, when a tin whisker 18 enters and traverses a gas-filled void 16, the tin whisker 18 buckles and continues growing in a different direction, often folding back on itself, instead of reentering the conformal coating matrix 15. Buckling occurs because the tin whisker portion that is inside a gas-filled void 16 lacks sufficient lateral support for the whisker to push back into the conformal coating matrix 15. As a tin whisker 18 collides with the coating matrix after traversing a gas-filled void 16, the tin whisker 18 begins to bend and continues to do so until the bending stress produces sufficient counter force to allow the tin whisker 18 to reenter the conformal coating matrix 15. Almost invariably, the tin whisker that reenters the conformal coating matrix 15 will be growing in a different direction than that at which the tin whisker 18 entered the gas-filled void. According to an exemplary embodiment, a significant differential between the lateral support inside and outside the gas filled void 16 is be created by selecting a relatively hard conformal coating matrix material. For example, epoxies and paralenes are exemplary relatively hard polymer materials that may be used as the coating matrix 15.

In order for the tin whisker 18 to buckle inside a gas-filled void 16 without substantial resistance, the voids 16 preferably have a diameter that is at least ten times the tin whisker width. For example, if a tin whisker has a width of 3 microns, the gas-filled voids 16 should have a diameter of at least about 30 microns. Since tin whiskers typically have widths of up to about microns, exemplary gas-filled voids 16 have average diameters of at least about 50 microns, although smaller voids may be formed if it is found that the tin whiskers are particularly thin growths. The tin whisker 18 becomes more bendable as it lengthens inside the gas-filled void 16. If the tin whisker 18 is too short, the coating matrix 15 at the point where the tin whisker 18 entered the void 16 will provide sufficient lateral support to enable the tin whisker 18 to re-penetrate the coating matrix 15 without buckling.

Turning now to FIG. 2, a flow diagram illustrates a general method for forming the previously-described conformal coating. First, a gas is infused into a liquid conformal coating composition as step 30. The gas is selected based on the chosen coating composition into which the gas is to be infused. Some exemplary gases include carbon dioxide, a noble gas such as argon or helium, hydrogen, nitrogen, and air. A gas's solubility in a particular coating composition, both at gas infusing temperatures and at coating temperatures, is an important consideration to ensure that the selected gas produces a relatively high density of gas-filled voids in the completed conformal coating. Furthermore, the concentration of the infused gas molecules is selected based on the total density of gas-filled voids that the gas molecules will produce in the completed conformal coating. For example, in an exemplary embodiment the conformal coating includes at least 30% of gas-filled voids by volume in order to create a high probability that a tin whisker growing from any given point along the underlying tin finish will enter a void. To obtain such a concentration of gas-filled voids, a liquid coating composition may need to be saturated with gas molecules. Further, the liquid coating composition may be heated during gas infusion to increase the gas's solubility in the liquid. In addition to heating the liquid, or as an alternative, the liquid may be placed in a pressurized chamber to increase the gas's solubility in the liquid.

Next, a tin plating or finish on an electrical substrate is coated with the coating material having the gas molecules dissolved therein as step 32. Just a few exemplary methods for covering the tin with the coating material include extrusion and dipping. A coating method is selected based on factors including the conformal coating liquid material, the likelihood for the gas infused therein to escape from the liquid during the coating step, and the suitability for a particular covering method for the electrical components being coated. Some methods such as deposition and spraying may be suitable for some coatings, but may disrupt the gas concentration in the liquid in other coatings. Extrusion and dipping may be preferred coating methods for some coatings since they require little if any change in temperature and/or pressure.

After covering the tin plated or finished electrical component with the conformal coating material, any necessary processing steps, including adjusting the temperature and/or pressure, are performed on the conformal coating as step 34. Decreasing the temperature and/or pressure will cause the gas molecules to cluster and form gas voids in the coating matrix. Heating, humidifying, solvent addition, and radiation (i.e. UV radiation) are just some additional processing steps that may react or improve the conformal coating material. The additional processing steps may cause binder and/or other matrix materials to react and conform the coating to the coated surfaces. The processing steps may also enable the gas-filled voids to be more evenly dispersed.

During or after the temperature and/or pressure adjusting steps, the conformal coating matrix composition is hardened as step 36. Hardening may comprise a chemical reaction such as a dehydration reaction or a curing reaction that captures the gas-filled voids as a permanent dispersion throughout the coating.

The several methods and coating materials therefore provide electrical assemblies and components having a tin plating or finish, and a conformal coating around the tin plating or finish. The gas-filled voids are growth disrupting materials that inhibit growth of any tin whiskers through the conformal coating.

## Claims

1. An electrical component, comprising:
a conductive substrate (10);
a tin layer (12) formed on the substrate; and
a conformal coating (14) formed on the tin layer to impede tin whisker growth, the conformal coating comprising:
a polymer matrix (15), and
gas-filled voids (16) dispersed throughout the polymer matrix.

2. The electrical component according to claim 1, wherein the gas-filled voids constitute at least 30% by volume of the conformal coating.

3. The electrical component according to claim 1, wherein the gas-filled voids are dispersed in a manner whereby at least one gas-filled void is present in any given cross-sectional slice of the conformal coating.

4. The electrical component according to claim 1, wherein the gas-filled voids have an average diameter greater than about 5 microns.

5. The electrical component according to claim 1, wherein the gas-filled voids are substantially homogenously dispersed throughout the polymer matrix.

6. A method for impeding tin whisker growth from a tin plating or finish (12) formed over an electrical component (10), the method comprising:
infusing (30) a gas into a liquid polymer;
covering (32) the tin plating or finish with a conformal coating (14) comprising the liquid polymer; and
adjusting (34) one or more of the temperature and pressure of the conformal coating to thereby create a dispersion of gas-filled voids (16) comprising the gas in the conformal coating.

7. The method according to claim 6, wherein the infusing and adjusting steps produce the gas-filled voids, which constitute at least 30% by volume of the conformal coating.

8. The method according to claim 7, wherein the infusing and adjusting steps produce the gas-fined voids, which have an average diameter greater than about 5 microns.

9. The method according to claim 7, wherein the infusing and adjusting steps produce the gas-filled voids, which are substantially homogenously dispersed throughout the polymer matrix.

10. The method according to claim 7, wherein the infusing step is performed until the liquid polymer is saturated with the gas.

## Patentansprüche

1. Elektrisches Bauteil, umfassend:
ein leitfähiges Trägermaterial (10);
eine auf dem Trägermaterial gebildete Zinnschicht (12); und
einen auf der Zinnschicht gebildeten gleichmäßigen Überzug (14) zur Verhinderung von Zinn-Whisker-Wachstum, wobei der gleichmäßige Überzug umfasst:
eine Polymermatrix (15) und
gasgefüllte Hohlräume (16), die in der Polymermatrix verteilt sind.

2. Elektrisches Bauteil nach Anspruch 1, wobei der Volumenanteil der gasgefüllten Hohlräume mindestens 30 % des gleichmäßigen Überzugs beträgt.

3. Elektrisches Bauteil nach Anspruch 1, wobei die gasgefüllten Hohlräume derart verteilt sind, dass mindestens ein gasgefüllter Hohlraum in einem beliebigen Querschnittsstück des gleichmäßigen Überzugs vorliegt.

4. Elektrisches Bauteil nach Anspruch 1, wobei die gasgefüllten Hohlräume einen Mitteldurchmesser von mehr als ungefähr 5 Mikrometern aufweisen.

5. Elektrisches Bauteil nach Anspruch 1, wobei die gasgefüllten Hohlräume in der Polymermatrix im Wesentlichen homogen verteilt sind.

6. Verfahren zur Verhinderung von Zinn-Whisker-Wachstum aus einer Verzinnung oder einem Zinnfinish (12), das sich über einem elektrischen Bauteil (10) bildete, wobei das Verfahren umfasst:
Aufgießen (30) eines Gases in ein flüssiges Polymer;
Beschichten (32) der Verzinnung oder des Zinnfinishs mit einem gleichmäßigen Überzug (14), der das flüssige Polymer umfasst; und
Regeln (34) der Temperatur und/oder des Drucks des gleichmäßigen Überzugs, um **dadurch** eine Verteilung von gasgefüllten Hohlräumen (16), welche das Gas im gleichmäßigen Überzug umfassen, zu erzeugen.

7. Verfahren nach Anspruch 6, wobei die Schritte des Aufgießens und des Regelns die gasgefüllten Hohlräume schaffen, deren Volumenanteil mindestens 30 % des gleichmäßigen Überzugs beträgt.

8. Verfahren nach Anspruch 7, wobei die Schritte des Aufgießens und des Regelns die gasgefüllten Hohlräume schaffen, die einen Mitteldurchmesser von mehr als ungefähr 5 Mikrometern aufweisen.

9. Verfahren nach Anspruch 7, wobei die Schritte des Aufgießens und des Regelns die gasgefüllten Hohlräume schaffen, die in der Polymermatrix im Wesentlichen homogen verteilt sind.

10. Verfahren nach Anspruch 7, wobei der Schritt des Aufgießens solange durchgeführt wird, bis das flüssige Polymer mit dem Gas gesättigt ist.

## Revendications

1. Composant électrique comprenant :
un substrat conducteur (10) ;
une couche d'étain (12) formée sur le substrat ; et
un revêtement enrobant (14) formé sur la couche d'étain pour empêcher la croissance de barbes d'étain, le revêtement enrobant comprenant :
une matrice polymère (15), et
des vides remplis de gaz (16) dispersés dans toute la matrice polymère.

2. Composant électrique selon la revendication 1, dans lequel les vides remplis de gaz constituent au moins 30 % en volume du revêtement enrobant.

3. Composant électrique selon la revendication 1, dans lequel les vides remplis de gaz sont dispersés d'une manière par laquelle au moins un vide rempli de gaz est présent dans n'importe quelle tranche de coupe donnée du revêtement enrobant.

4. Composant électrique selon la revendication 1, dans lequel les vides remplis de gaz ont un diamètre moyen supérieur à environ 5 µm.

5. Composant électrique selon la revendication 1, dans lequel les vides remplis de gaz sont dispersés de façon sensiblement homogène dans toute la matrice polymère.

6. Procédé pour empêcher la croissance de barbes d'étain à partir d'un revêtement ou d'une finition d'étain (12) formé sur un composant électrique (10), le procédé comprenant :
l'infusion (30) d'un gaz dans un polymère liquide ;
le recouvrement (32) du revêtement ou de la finition d'étain avec un revêtement enrobant (14) comprenant le polymère liquide ; et
l'ajustement (34) de la température et/ou de la pression du revêtement enrobant pour créer ainsi une dispersion de vides remplis de gaz (16) comprenant le gaz dans le revêtement enrobant.

7. Procédé selon la revendication 6, dans lequel les étapes d'infusion et d'ajustement produisent les vides remplis de gaz, qui constituent au moins 30 % en volume du revêtement enrobant.

8. Procédé selon la revendication 7, dans lequel les étapes d'infusion et d'ajustement produisent les vides remplis de gaz, qui ont un diamètre moyen supérieur à environ 5 µm.

9. Procédé selon la revendication 7, dans lequel les étapes d'infusion et d'ajustement produisent les vides remplis de gaz, qui sont dispersés de façon sensiblement homogène dans toute la matrice polymère.

10. Procédé selon la revendication 7, dans lequel l'étape d'infusion est exécutée jusqu'à ce que le polymère liquide soit saturé avec le gaz.
